# FASCICULE DE BREVET EUROPEEN

(11) **EP 2 022 816 B1**
(45) Date de publication et mention de la délivrance du brevet: **07.03.2012**
(21) Numéro de dépôt: 08305408.0
(22) Date de dépôt: 21.07.2008
(51) Int. Cl.: C08J 7/04, C09D 127/12, H01L 51/05

(54) **Couche d'accroche sur des polymères fluorés**
Haftschicht auf fluorierten Polymeren
Adhesion layer on fluorinated polymers

(30) Priorité: 01.08.2007 FR 0705621
(43) Date de publication de la demande: 11.02.2009
(73) Titulaire: Commissariat à l'Énergie Atomique et aux Énergies Alternatives, 75015 Paris (FR)
(72) Inventeur: Serbutoviez, Christophe, 38500, VOIRON (FR); Benwadih, Mohamed, 94500, CHAMPIGNY SUR MARNE (FR); Verilhac, Jean-Marie, 38000, GRENOBLE (FR)
(74) Mandataire: Vuillermoz, Bruno

(56) Documents cités:
- WO-A-2007/082584
- GB-A- 2 302 693
- US-A- 5 993 907
- US-A1- 2005 104 058
- US-A1- 2005 247 928
- US-A1- 2006 151 781

## Description

### DOMAINE DE L'INVENTION

La présente invention a trait aux dispositifs intégrant des couches en polymères fluorés.

Elle propose de recouvrir, au moins partiellement, ces couches à l'aide d'une couche additionnelle dite « d'accroche », permettant le dépôt aisé de couches ultérieures.

Une telle couche d'accroche est réalisée à l'aide de polymères présentant au moins une fonction fluorée et au moins une fonction acide ou base.

### ETAT ANTERIEUR DE LA TECHNIQUE

Le recours aux polymères fluorés (ou fluoropolymères) est devenu courant dans divers domaines techniques.

Ainsi, les fluoropolymères sont utilisés dans la fabrication de composants électroniques tels que les transistors organiques, pour l'isolation électrique, et dans la fabrication de pièces mécaniques soumises à des conditions extrêmes d'utilisation (en température ou en présence de solvants agressifs).

Dans le cas particulier de l'électronique organique, les fluoropolymères, et notamment le Cytop^{®} (nom commercial du poly perfluoro butenyl vinyl ether), présentent des propriétés particulièrement adaptées pour constituer le diélectrique de grille d'un transistor.

Le document US 2006/151781 décrit un transistor organique à couche mince comprenant une couche de polymère fluoré entre la couche isolant la grille et la couche semiconductrice organique.

Le document US 2005/104058 décrit un dispositif organique à effet de champ comprenant une couche en polymère fluoré éventuellement recouverte d'une couche de permittivité plus élevée.

Toutefois, l'utilisation de tels polymères fluorés pose les problèmes suivants, non résolus à ce jour :
- il est impossible de déposer par voie humide d'autres couches sur un fluoropolymère préalablement déposé en couche mince, et ce quelque soit la méthode de dépôt mise en oeuvre (« *spin coating »* ou diverses méthodes d'impression) ;
- il est impossible de coller entre elles deux pièces en fluoropolymères, ou de coller une matière plastique sur un fluoropolymère.

Ceci rend donc très délicate la fabrication de dispositifs complexes comprenant différents éléments indispensables à leur fonctionnement. C'est par exemple le cas pour un transistor complet, dans lequel la mise en place du diélectrique requiert des étapes ultérieures de fabrication.

Il existe donc un besoin évident de développer des solutions techniques permettant de faciliter et d'améliorer les dépôts sur des couches à base de polymère fluorés.

### EXPOSE DE L'INVENTION

La présente invention repose sur la mise en évidence, par le Demandeur, que certains polymères fluorés développent des aptitudes à adhérer aux matériaux, et notamment à des polymères fluorés.

Pour l'essentiel, ces polymères fluorés particuliers, présentant des propriétés adhésives, sont porteurs d'au moins une fonction acide ou base.

Selon un premier aspect, la présente invention concerne donc un dispositif, notamment un transistor, comprenant une couche réalisée en polymère fluoré dont une partie au moins de la surface est recouverte d'au moins un polymère présentant au moins une fonction fluorée et au moins une fonction acide ou base.

Selon l'invention, la composition comprenant au moins le polymère présentant au moins une fonction fluorée et au moins une fonction acide ou base forme une couche d'accroche sur le polymère fluoré. Cette couche d'accroche est elle-même recouverte, en partie ou entièrement, par une ou plusieurs autres couches réalisées à l'aide de matériaux d'intérêt.

En d'autres termes, l'invention porte sur un dispositif comprenant une couche réalisée en polymère fluoré dont une partie au moins de la surface est recouverte d'une composition comprenant un polymère présentant au moins une fonction fluorée et au moins une fonction acide ou base et formant une couche d'accroche sur ledit polymère fluoré, ladite couche d'accroche étant recouverte en tout ou en partie par une autre couche.

Par définition, le dispositif est donc en partie constitué d'un premier polymère fluoré. Cette partie est appelée « couche » dans la mesure où elle présente des surfaces externes qui sont vouées, en partie ou en totalité, à être recouvertes par au moins la couche d'accroche selon l'invention.

On entend ici, par polymère fluoré, un polymère ou un copolymère, dont l'un au moins des monomères qui le composent contient au moins un atome de fluor (F) par monomère. Ce polymère peut être réticulé ou non réticulé.

De tels polymères sont, par exemple, choisis dans la liste suivante :
- Teflon^{®}: nom commercial pour le polytétrafluoroéthylène (PTFE) (commercialisé par DuPont) ;
- Cytop^{®} : nom commercial pour le poly perfluoro butenyl vinyl ether (commercialisé par ASHAI GLASS) ;
- Halar^{®} (commercialisé par SOLVAY SOLEXIS) ;
- Hyflon^{®} (commercialisé par SOLVAY SOLEXIS) ;
- Parylene-F(commercialisé par exemple par ALDRICH).

A noter qu'il s'agit de références bien connues de l'homme du métier dans le domaine des polymères, mais dont la formule chimique exacte n'est pas toujours disponible.

Dans cette liste, le Cytop^{®} est avantageusement choisi.

Il apparaîtra clairement, à la lecture de la suite de la description, que ce premier polymère fluoré est dépourvu de fonction acide ou base.

Le second polymère, utilisé pour la formation de la couche d'accroche selon l'invention, est un polymère ou un copolymère défini comme suit :
- l'un au moins des monomères qui le composent contient au moins un atome de fluor (F) par monomère. A ce titre, il s'agit donc d'un deuxième fluoropolymère ;
- l'un au moins des monomères qui le composent contient une fonction acide ou base. Dans le cadre de l'invention, les fonctions acide ou base sont définies selon Brönsted ou Lewis.

Des polymères répondant à cette définition sont par exemple :
- Nafion^{®} (DUPONT);
- Hyfion Ion^{®} (SOLVAY SOLEXIS)
- Flemion^{®} (ASHAI GLASS).

Là encore, il s'agit de références bien connues de l'homme du métier dans le domaine des polymères, mais dont la formule chimique exacte n'est pas disponible.

De manière privilégiée, la fonction acide est apportée par une fonction carboxylique, phosphonique, sulfonique, sulfone ou Si(CH₃)₃. La fonction basique peut être une amine.

Selon un mode de réalisation avantageux, le monomère présentant au moins une fonction fluorée est de même nature que le monomère présent dans le polymère fluoré. C'est par exemple le cas pour le couple Teflon^{®} (premier fluoropolymère)/ Nafion^{®} (deuxième fluoropolymère) qui comprennent, tous deux, des monomères de tétrafluoroéthylène.

Avantageusement, la fonction fluorée et la fonction acide ou base sont portées par le même monomère. C'est par exemple le cas du Nafion^{®} dont les monomères de tétrafluoroéthylène incorporent des groupes perfluorovinyl éther terminés par des groupements sulfoniques.

Il s'avère qu'un tel polymère porteur d'au moins une fonction fluorée et d'au moins une fonction acide ou base présente des aptitudes à adhérer tant aux polymères fluorés, tels que le Téflon^{®} ou le Cytop^{®} (ou aux matériaux équivalents), qu'aux autres matériaux, par exemple de la colle. Le Teflon^{®} ainsi recouvert permet alors l'adhésion d'une encre conductrice, d'une autre pièce en Teflon^{®} ou en une autre matière (par exemple le mélaminé), etc...

La couche d'accroche ainsi formée, qui présente avantageusement une épaisseur comprise entre 20 nm et 2 µm, peut ainsi être recouverte en partie ou en totalité par une ou plusieurs autres couches réalisées à l'aide de matériaux d'intérêt. Il peut s'agit d'électrodes, de matériaux semi-conducteurs, de diélectriques, de couches d'encre ou de colle

Il est à noter que pour les applications ayant trait à l'électronique en particulier, il est souhaitable que les groupements acide ou base présents dans le polymère fluoré ne s'orientent pas sous champ électrique. Pour lutter contre ce phénomène, il est préconisé d'associer, dans la composition servant à la formation de la couche d'accroche, des composés de type molécule ou polymère établissant des liaisons avec les sites acide ou base du polymère fluoré. Ces liaisons peuvent être de type interactions de faible énergie, par exemple des liaisons hydrogènes. Alternativement, une réaction acido-basique peut avoir lieu en solution entre le polymère fluoré et le composé.

Par ailleurs, il est envisageable de mélanger le polymère fluoré porteur des fonctions acide ou base directement avec un matériau d'intérêt, tel qu'une résine notamment de photolithographie, des encres notamment conductrices, ou des diélectriques. Un tel mélange présente également une forte affinité pour des substrats à base de polymère fluoré. Dans ce cas de figure, la couche disposée sur la couche d'accroche peut par exemple être constituée d'un métal pour constituer des contacts électriques.

Selon un mode de réalisation privilégié, le dispositif selon l'invention est un transistor.

La présente invention permet donc de modifier la surface d'un fluoropolymère à l'aide d'un second fluoropolymère et de rendre ainsi la surface du premier fluoropolymère compatible avec des procédés tels que l'impression, le « spin coating » ou le collage.

Selon un autre aspect, l'invention concerne donc un procédé de fabrication d'un dispositif tel que défini ci-dessus comprenant :
- dans un premier temps, le dépôt, sur tout ou partie de la surface externe d'une couche en polymère fluoré, d'une composition comprenant un polymère présentant au moins une fonction fluorée et au moins une fonction acide ou base, de manière à former une couche d'accroche après séchage ;
- dans un second temps, le dépôt d'un matériau d'intérêt sur cette couche d'accroche, de manière à former une autre couche (dite fonctionnelle) après séchage.

En d'autres termes, l'invention porte sur un procédé de fabrication d'un dispositif tel que décrit ci-dessus, comprenant les étapes suivantes :
- une étape de dépôt, sur au moins une partie de la surface externe d'une couche en polymère fluoré, d'une composition comprenant un polymère présentant au moins une fonction fluorée et au moins une fonction acide ou base et formant une couche d'accroche après séchage ;
- une étape de dépôt d'une autre couche sur cette couche d'accroche.

Le dépôt du second polymère fluoré sur le premier peut se faire soit par trempage, soit par « spin coating » ou par impression (inkjet, flexographie, héliographie, ...). Ces mêmes techniques peuvent être mises en oeuvre pour le second dépôt.

Le second polymère, porteur d'au moins une fonction fluorée et d'au moins une fonction acide ou base est, en général, formulé dans une composition adaptée à la technique de dépôt mise en oeuvre.

Une telle composition peut prendre la forme d'une solution comprenant de 0,3 à 5% en masse du polymère présentant au moins une fonction fluorée et au moins une fonction acide ou base.

Un solvant adapté à la mise en solution dudit polymère est choisi et incorporé à la composition. Il peut par exemple s'agir de l'isopropanol.

Typiquement, après dépose et séchage, ce second polymère forme une couche mince dont l'épaisseur est comprise entre 20 nm et 2 µm. Cette épaisseur dépend notamment de la concentration en fluoropolymère de la couche sur laquelle est réalisé le dépôt.

Cette composition peut également être enrichie à l'aide d'un ou plusieurs polymères ou des molécules dont la structure chimique est proche de la structure de la couche ou du matériau qui sera rapportée sur le second polymère. En effet, dans une étape ultérieure du procédé de fabrication, un matériau d'intérêt est avantageusement destiné à être déposé sur la couche ainsi formée.

A titre d'exemple, une telle composition a la formule suivante (% en masse) :
- 4% Nafion 2021 ;
- 90% isopropanol ;
- 4% polyvinyl phénol ;
- 2% mélamine.

La couche d'accroche obtenue à l'aide de cette composition est particulièrement adaptée pour recevoir (et notamment pour être recouverte en tout ou en partie) une couche à base de polyvinyl phénol réticulé par de la mélamine formol. Cette couche permet de limiter les fuites électriques de l'empilement complet.

### DESCRIPTION DETAILLEE DE L'INVENTION

La manière dont l'invention peut être réalisée et les avantages qui en découlent ressortiront mieux des exemples de réalisation qui suivent, donnés à titre indicatif et non limitatif, à l'appui des figures annexées.
La figure 1 représente le schéma d'un transistor obtenu selon les procédés de l'art antérieur.
La figure 2 représente le schéma d'un transistor obtenu selon la présente invention, comportant une couche d'accroche.
La figure 3 représente le schéma d'un transistor obtenu selon la présente invention, comportant une couche d'accroche et une couche additionnelle de diélectrique.
La figure 4 représente la coupe de deux pièces en polymères fluorés collées entre elles à l'aide de couches d'accroche selon l'invention.

### Première application : transistors organiques

Il est maintenant admis que, pour obtenir des transistors organiques qui présentent peu d'hystérésis et de fortes mobilités, il est nécessaire que le diélectrique de grille soit constitué d'un polymère présentant une faible valeur de ε (dit low K) (J. Veres et al. « Gate Insulators in Organic Field-Effect Transistors », Chem. Mater. 2004, 16, 4543-4555).

Parmi les polymères low K souvent utilisés pour la fabrication de transistors organiques, les fluoropolymères sont des matériaux de choix. Cependant, l'intégration de tels matériaux dans la fabrication de transistor n'est pas aisée. Le problème majeur observé est qu'il est impossible de déposer sur ces matériaux, par des méthodes par voie liquide (« *spin coating»* ou impression), les autres couches qui constituent l'empilement d'un transistor.

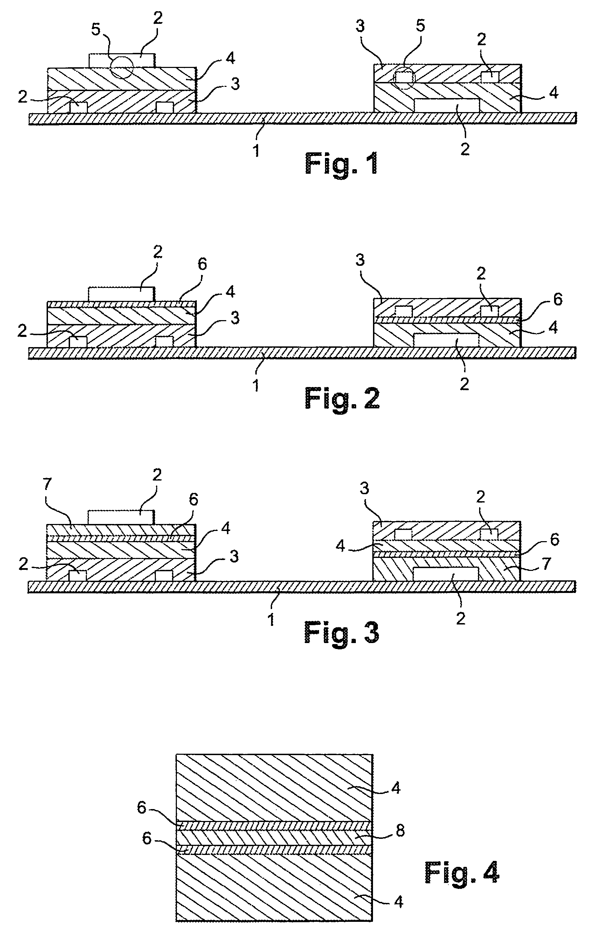

La figure 1 illustre les différentes étapes dans la fabrication d'un transistor organique selon l'art antérieur.

Pour la grille haute, sont successivement déposés sur un substrat (1) :
- deux électrodes (2), appelées source et drain ;
- un matériau semi-conducteur (3) ;
- une couche en polymère fluoré (4) correspondant au premier fluoropolymère ;
- la seconde électrode (2) appelée grille.

Et pour la grille basse :
- une électrode (2) appelée grille ;
- une couche en polymère fluoré (4) correspondant au premier fluoropolymère ;
- les secondes électrodes (2), appelées source et drain ;
- un matériau semi-conducteur (3).

En raison des difficultés susmentionnées de dépôt sur la couche en polymère fluoré (4), il existe un défaut d'adhérence (5) entre cette couche et la couche supérieure, à savoir l'électrode (2) et/ou le matériau semi-conducteur (3). On constate en outre un défaut d'uniformité des couches.

Grâce à la présente invention, il est possible de déposer des encres conductrices par sérigraphie ou par impression jet d'encre. Il est alors possible d'imprimer par exemple la grille ou la source et le drain d'un transistor.

La figure 2 illustre la mise en place d'une couche d'accroche selon l'invention (6) entre la couche en fluoropolymère (4) et les électrodes (2) et/ou le matériau semi-conducteur (3).

Sur une telle couche d'accroche (6), il est aussi possible de déposer d'autres diélectriques (7) en couche mince, tels que des polyimides ou des silsesquioxane, ou du PVP (polyvynilphénol) mélamine formol, comme illustré à la figure 3. Là encore, ce dépôt peut être réalisé à l'aide de techniques classiques du type « spin coating » ou des méthodes d'impression.

### Seconde application : Motifs sur tissus ou substrats hydrophobes

Une couche d'accroche selon l'invention peut être utilisée pour l'impression de motifs sur des tissus ou des substrats hydrophobes, dont l'hydrophobicité est assurée par un polymère fluoré classique.

Dans ce cas, le substrat est traité par un polymère présentant au moins une fonction fluorée et au moins une fonction acide ou base, par trempage ou par des méthodes d'impression du type flexographie, héliographie inkjet. Après séchage, la surface devient compatible avec des méthodes classiques d'impression.

### Troisième application: Collage de deux pièces en polymères fluorés

Une couche d'accroche selon l'invention peut être utilisée pour le collage d'une pièce moulée ou usinée dans un fluoropolymère, avec un second matériau pouvant être non obligatoirement un fluoropolymère.

Dans ce cas, illustré à la figure 4, les pièces en fluoropolymère (4) sont revêtues d'un polymère présentant au moins une fonction fluorée et au moins une fonction acide ou base (6), par trempage. Leurs interfaces deviennent compatibles avec des colles du type cyanoacrylate ou époxy/amine, époxy cationique, acrylique UV (8). Il est alors possible d'obtenir une rupture cohésive du joint de colle.

### Quatrième application : Association du polymère porteur d'au moins une fonction fluorée et d'au moins une fonction acide ou base avec d'autres composés

### Exemple 1:

A de la résine de photolithographie S1818 (SHIPLEY), est ajoutée 5% en masse d'une solution de Nafion^{®} 2021 (DUPONT). Ce mélange est déposé par « *spin coating* » (tournette) sur un substrat de polyéthylène naphthalène, préalablement revêtu d'une couche du fluoropolymère Cytop^{®}. La résine est recuite, exposée et développée selon les conditions recommandées par le fabricant de cette résine. Il est alors possible de procéder aux étapes de gravure de la couche de Cytop^{®}.

### Exemple 2:

A de l'encre conductrice de sérigraphie 5025 (DUPONT), est ajoutée 8 % en masse d'une solution de Nafion^{®} 2021 (DUPONT). Le mélange ainsi obtenu est sérigraphié sur une couche de fluoropolymère de type Cytop^{®} au travers d'un stencil approprié. Il est alors possible d'imprimer par exemple la grille du transistor directement sur un diélectrique à base de fluoropolymère.

### Exemple 3:

A de l'encre conductrice pour impression jet d'encre TEC-IJ-010 (INKTECK), est ajoutée 0,2 % en masse d'une solution de Nafion^{®} 2021 (DUPONT). Le mélange ainsi obtenu est compatible avec la tête d'impression jet d'encre de 60 microns commercialisée par MICROFAB. Après impression jet d'encre et recuit à 100°C, pendant 20 minutes, d'un tel mélange sur une couche de fluoropolymère de type Cytop^{®}, on obtient une couche conductrice. Un tel mélange permet d'imprimer par exemple la grille du transistor sur un diélectrique à base de fluoropolymère.

### Exemple 4:

Un transistor organique de configuration grille haute est fabriqué avec comme semiconducteur, du P3HT (poly[3-n-hexylthiophène-2,5-diyl), et comme diélectrique, le fluoropolymère Cytop^{®}. Les électrodes de source et de drain sont en or. A une solution composée de 1 g de Nafion^{®} 2021 (DUPONT) et de 20 g d'isopropanol, est ajouté 0,05 g de poly 4-vinylpyridine. Ce mélange est imprimé par sérigraphie sur la surface du fluoropolymère Cytop^{®}. La grille du transistor est imprimée avec une encre contenant des nanoparticules d'argent, telle que l'encre cabot AG-IJ-G-100-S. Un tel transistor, après application d'un champ électrique constant sur la grille, présente des courbes de vieillissement électrique compatibles pour des applications en électronique organique.

## Revendications

1. Dispositif comprenant une couche réalisée en polymère fluoré dont une partie au moins de la surface est recouverte d'une composition comprenant un polymère présentant au moins une fonction fluorée et au moins une fonction acide ou base et formant une couche d'accroche sur ledit polymère fluoré, ladite couche d'accroche étant recouverte en tout ou en partie par une autre couche.

2. Dispositif selon la revendication 1, ***caractérisé* en ce que** la fonction acide est apportée par une fonction carboxylique, phosphonique, sulfonique, sulfone ou Si(CH₃)₃.

3. Dispositif selon la revendication 1, ***caractérisé* en ce que** la fonction base est apportée par une amine.

4. Dispositif selon l'une des revendications 1 à 3, ***caractérisé* en ce que** le monomère présentant au moins une fonction fluorée est de même nature que le monomère présent dans le polymère fluoré.

5. Dispositif selon l'une des revendications 1 à 4, ***caractérisé* en ce que** la fonction fluorée et la fonction acide ou base sont portées par le même monomère.

6. Dispositif selon l'une des revendications précédentes, ***caractérisé* en ce que** le polymère fluoré est du polytétrafluoroéthylène (PTFE).

7. Dispositif selon l'une des revendications précédentes, ***caractérisé* en ce que** la composition formant la couche d'accroche comprend en outre un composé susceptible d'interagir avec les fonctions acide ou base du polymère.

8. Dispositif selon l'une des revendications précédentes, ***caractérisé* en ce que** la composition formant la couche d'accroche comprend en outre une résine, une encre ou un diélectrique.

9. Dispositif selon l'une des revendications précédentes, ***caractérisé* en ce que** la couche d'accroche présente une épaisseur comprise entre 20 nm et 2 µm.

10. Dispositif selon l'une des revendications précédentes, ***caractérisé* en ce que** le dispositif est un transistor.

11. Dispositif selon l'une des revendications précédentes, ***caractérisé* en ce que** la couche recouvrant en tout ou en partie la couche d'accroche est une électrode, un matériau semi-conducteur, un diélectrique, une couche d'encre ou une couche de colle.

12. Procédé de fabrication d'un dispositif selon l'une des revendications 1 à 11, comprenant les étapes suivantes :
- une étape de dépôt, sur au moins une partie de la surface externe d'une couche en polymère fluoré, d'une composition comprenant un polymère présentant au moins une fonction fluorée et au moins une fonction acide ou base et formant une couche d'accroche après séchage ;
- une étape de dépôt d'une autre couche sur cette couche d'accroche.

13. Procédé de fabrication selon la revendication 12 ***caractérisé* en ce que** les dépôts sont réalisés par trempage, par « spin coating » ou par impression.

14. Procédé de fabrication selon la revendication 12 ou 13, ***caractérisé* en ce que** la composition comprenant un polymère présentant au moins une fonction fluorée et au moins une fonction acide ou base contient un solvant, avantageusement de l'isopropanol.

## Claims

1. A device comprising a layer made from a fluoropolymer, of which at least part of the surface is covered with a composition comprising a polymer having at least one fluorinated function and at least one acid or base function and forming a bonding layer on said fluoropolymer, said bonding layer being fully or partly covered by another layer.

2. The device as claimed in claim 1, **characterized in that** the acid function is provided by a carboxylic, phosphonic, sulfonic, sulfone or Si(CH₃)₃ function.

3. The device as claimed in claim 1, **characterized in that** the base function is provided by an amine.

4. The device as claimed in one of claims 1 to 3, **characterized in that** the monomer having at least one fluorinated function is of the same type as the monomer present in the fluoropolymer.

5. The device as claimed in one of claims 1 to 4, **characterized in that** the fluorinated function and the acid or base function are carried by the same monomer.

6. The device as claimed in one of the preceding claims, **characterized in that** the fluoropolymer is polyterafluoruethylene (PTFE).

7. The device as claimed in one of the preceding claims, ***characterized* in that** the composition forming the bonding layer further comprises a compound capable of interacting with the acid or base functions of the polymer.

8. The device as claimed in one of the preceding claims, **characterized in that** composition forming the bonding layer further comprises a resin, an ink or a dielectric.

9. The device as claimed in one of the preceding claims, **characterized in that** the bonding layer has a thickness of between 20 nm and 2 µm.

10. The device as claimed in one of the preceding claims, **characterized in that** the device is a transistor.

11. The device as claimed in one of the preceding claims, **characterized in that** the layer covering all or part of the bonding layer is an electrode, a semiconductive material, a dielectric, a layer of ink or a layer of adhesive.

12. A method for fabricating a device as claimed in one of claims 1 to 11, comprising the following steps:
- a step of deposition, on at least part of the outer surface of a fluoropolymer layer, of a composition comprising a polymer having at least one fluorinated function and at least one acid or base function and forming a bonding layer after drying;
- a step of deposition of another layer on this bonding layer.

13. The fabrication method as claimed in claim 12, **characterized in that** the depositions are carried out by dip-coating, spin-coating or printing.

14. The fabrication method as claimed in either of claims 12 and 13, **characterized in that** the composition comprising a polymer having at least one fluorinated function and at least one acid or base function contains a solvent, advantageously isopropanol.

## Patentansprüche

1. Vorrichtung, die eine aus Fluorpolymer hergestellte Schicht umfasst, von der wenigstens ein Teil der Oberfläche von einer Zusammensetzung bedeckt ist, die ein Polymer umfasst, das wenigstens eine Fluorfunktion und wenigstens eine Säure- oder Basefunktion aufweist und eine Haftschicht auf dem Fluorpolymer bildet, wobei die Haftschicht ganz oder teilweise von einer anderen Schicht bedeckt ist.

2. Vorrichtung gemäß Anspruch 1, **dadurch gekennzeichnet, dass** die Säurefunktion durch eine Carbonsäure-, Phosphonsäure-, Sulfonsäure-, Sulfon- oder Si(CH₃)₃-Funktion bereitgestellt wird.

3. Vorrichtung gemäß Anspruch 1, **dadurch gekennzeichnet, dass** die Basenfunktion durch ein Amin bereitgestellt wird.

4. Vorrichtung gemäß einem der Ansprüche 1 bis 3, **dadurch gekennzeichnet, dass** das Monomer, das wenigstens eine Fluorfunktion aufweist, dieselbe Natur hat wie das Monomer, das im Fluorpolymer vorliegt.

5. Vorrichtung gemäß einem der Ansprüche 1 bis 4, **dadurch gekennzeichnet, dass** die Fluorfunktion und die Säure- oder Basefunktion durch dasselbe Monomer getragen werden.

6. Vorrichtung gemäß einem der vorangehenden Ansprüche, **dadurch gekennzeichnet, dass** das Fluorpolymer Polytetrafluorethylen (PTFE) ist.

7. Vorrichtung gemäß einem der vorangehenden Ansprüche, **dadurch gekennzeichnet, dass** die Zusammensetzung, die die Haftschicht bildet, außerdem eine Verbindung umfasst, die geeignet ist, mit den Säure- oder Basefunktionen des Polymers zu wechselwirken.

8. Vorrichtung gemäß einem der vorangehenden Ansprüche, **dadurch gekennzeichnet, dass** die Zusammensetzung, die die Haftschicht bildet, außerdem ein Harz, eine Tinte und ein Dielektrikum umfasst.

9. Vorrichtung gemäß einem der vorangehenden Ansprüche, **dadurch gekennzeichnet, dass** die Haftschicht eine Dicke von zwischen 20 nm und 2 µm umfasst.

10. Vorrichtung gemäß einem der vorangehenden Ansprüche, **dadurch gekennzeichnet, dass** die Vorrichtung ein Transistor ist.

11. Vorrichtung gemäß einem der vorangehenden Ansprüche, **dadurch gekennzeichnet, dass** die Schicht, die die Haftschicht ganz oder teilweise bedeckt, eine Elektrode, ein Halbleitermaterial, ein Dielektrikum, eine Tintenschicht oder eine Klebstoffschicht ist.

12. Herstellungsverfahren für eine Vorrichtung gemäß einem der Ansprüche 1 bis 11, umfassend die folgenden Stufen:
- eine Stufe der Abscheidung auf wenigstens einem Teil der äußeren Oberfläche einer Schicht aus Fluorpolymer einer Zusammensetzung, die ein Polymer umfasst, das wenigstens eine Fluorfunktion und wenigstens eine Säure- oder Basefunktion aufweist und nach Trocknung eine Haftschicht bildet;
- eine Stufe der Abscheidung einer anderen Schicht auf dieser Haftschicht.

13. Herstellungsverfahren gemäß Anspruch 12, **dadurch gekennzeichnet, dass** die Abscheidungen durch Tauchbehandlung, durch Schleuderbeschichtung oder durch Druck durchgeführt werden.

14. Herstellungsverfahren gemäß Anspruch 12 oder 13, **dadurch gekennzeichnet, dass** die Zusammensetzung, die ein Polymer umfasst, das wenigstens eine Fluorfunktion und wenigstens eine Säure- oder Basefunktion aufweist, ein Lösungsmittel, vorzugsweise Isopropanol, enthält.
